# EUROPEAN PATENT APPLICATION

(11) **EP 2 733 159 A1**
(43) Date of publication of application: **21.05.2014**
(21) Application number: 12811497.2
(22) Date of filing: 02.07.2012
(51) Int. Cl.: C08G 73/06, C08J 5/24, C09J 179/04, H01B 3/30, H01L 23/29, H01L 23/31

(54) **CURABLE RESIN COMPOSITION AND PROCESS FOR PRODUCING CURED PRODUCTS USING SAME**

(30) Priority: 11.07.2011 JP 2011152631
(71) Applicant: Mitsubishi Gas Chemical Company, Inc., Tokyo 100-8324 (JP)
(72) Inventor: TSUBUKU Makoto, Niigata-shi Niigata 950-3112 (JP); IKENO Taketo, Niigata-shi Niigata 950-3112 (JP); KATAGIRI Masayuki, Niigata-shi Niigata 950-3112 (JP); SUGANO Yuuichi, Niigata-shi Niigata 950-3112 (JP)
(74) Representative: HOFFMANN EITLE
(86) International application number: PCT/JP2012/066916
(87) International publication number: WO 2013/008667

(57) **Abstract**

A curable resin composition which is in a liquid form at ordinary temperature and provides a cured product having excellent heat resistance and a low thermal expansion rate is provided. The curable resin composition according to the present invention comprises: a cyanate ester compound (A) represented by the following formula (I); and a curing accelerator (B): 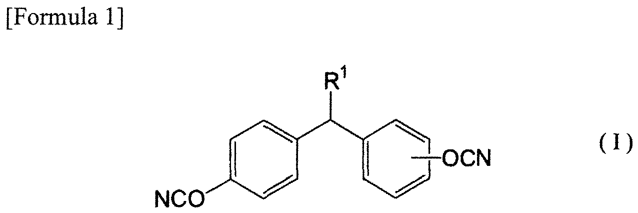 wherein R¹represents a hydrocarbon group having 2 to 20 carbon atoms.

## Description

### Technical Field

The present invention relates to a curable resin composition containing a cyanate ester compound, and a method for manufacturing a cured product using the same. In particular, the present invention relates to a curable resin composition which is in a liquid form at ordinary temperature and provides a cured product having excellent heat resistance and a low thermal expansion rate, and a method for manufacturing a cured product using the same.

### Background Art

In recent years, there have been many electronic devices featured by keywords of light, thin, short, and compact, such as a mobile phone, an ultraslim liquid crystal TV and a plasma TV, and a lightweight laptop computer in the field of a semiconductor-related material. Therefore, very high properties have been required for a package material. Particularly, a tip package has a complicated structure, which increases the number of elements hardly sealed by sealing other than liquid sealing. For example, it is necessary to partially seal an element having a cavity-down type structure such as EBGA. Transfer molding cannot deal with the element. For such a reason, development of a highly-functional liquid curable resin material as a sealant has been required.

In case of the liquid sealant, because of the difficulty of highly filling of a filler and raising of Tg (glass transition temperature) of a matrix resin itself unlike a powder sealant, the coefficient of thermal expansion of the sealant tends to be increased. Therefore, the liquid sealant has solder heat resistance and heat shock resistance inferior to those of the powder sealant subjected to transfer molding. As a result, a crack in a resin or a chip is more likely to be generated by a stress generated by the difference between the coefficient of thermal expansion of the liquid sealant and the coefficient of thermal expansion of a chip, which disadvantageously decreases the reliability of a semiconductor device. Therefore, a resin for a liquid sealant, which has high Tg and a low coefficient of thermal expansion, has been required.

Epoxy resin compositions containing a bisphenol A-based epoxy resin or an alicyclic epoxy resin or the like as a main ingredient, a liquid acid anhydride or phenol novolac as a curing agent, and an additive such as an inorganic filler are proposed as liquid sealing resin compositions for sealing a semiconductor element (for example, see Patent Literatures 1, 2, and 3). However, the resin compositions containing the bisphenol A-based epoxy resin or the alicyclic epoxy resin or the like as the main ingredient have low Tg and a large coefficient of thermal expansion in a high temperature range. These resin compositions also have a large dielectric constant and dielectric loss in a high-frequency region, which do not necessarily satisfy the requirements of miniaturization, high density, and speeding up of the semiconductor device.

On the other hand, a cyanate ester resin has been known through the ages as a thermosetting resin having excellent heat resistance, a low dielectric constant, and low dielectric loss. Particularly, a resin composition using a bisphenol A-based cyanate ester resin and a bismaleimide compound in combination, as proposed in Patent Literature 4, is referred to as a "BT resin". Since the BT resin has an excellent electrical property, mechanical property, and chemical resistance or the like, and is suitable as a sealing material for a semiconductor element. However, because the bisphenol A-based cyanate ester is a crystalline compound having a melting point of 80°C, the bisphenol A-based cyanate ester cannot be used as it is as a liquid sealing material, and it is necessary to use the bisphenol A-based cyanate ester and the other ingredient being in liquid form at ordinary temperature in combination. However, the combination use of the other ingredient provides the influence of the added ingredient to the bisphenol A-based cyanate ester, and decreases the degree of freedom of blending of the composition, which may hinder functional improvement.

For example, Patent Literature 5 discloses a resin composition using a triphenylmethane-based cyanate ester compound to improve thermal expansibility. However, the triphenylmethane-based cyanate ester compound is a solid at ordinary temperature, and is insufficient as the liquid sealing material. Furthermore, Patent Literature 6 discloses that a difunctional cyanatophenyl-based cyanate ester compound in which two cyanatophenyl groups are bonded via an asymmetric alkylene group has a low viscosity and noncrystallinity, and a resin cured product using the compound has an excellent heat deformation temperature and bending strength. Examples thereof include bis(4-cyanatophenyl)-2,2-propane, bis(4-cyanatophenyl)-1,1-ethane, and bis(4-cyanatophenyl)-2,2-butane. However, because the above compounds have a heat deformation temperature, regarded as an index of heat resistance, of about 200 to 250°C, the above compounds have insufficient heat resistance as the liquid sealant.

### Citation List

### Patent Literature

Patent Literature 1: Japanese Patent Laid-Open No. 2002-241469
Patent Literature 2: Japanese Patent Laid-Open No. 2003-160639
Patent Literature 3: Japanese Patent Laid-Open No. 2007-5750
Patent Literature 4: Japanese Patent Laid-Open No. H7-70315
Patent Literature 5: Japanese Patent Laid-Open No. 2006-169317
Patent Literature 6: Japanese Patent Laid-Open No. S63-150257

### Summary of Invention

Recently, the present inventors found that a curable resin composition using a specific bifunctional cyanate ester compound and a curing accelerator in combination is in a liquid form at ordinary temperature, and a cured product thereof has excellent heat resistance and a low thermal expansion rate. The present invention is based on these findings.

Therefore, it is an object of the present invention to provide a curable resin composition which is in a liquid form at ordinary temperature and provides a cured product having excellent heat resistance and a low thermal expansion rate.

It is another object of the present invention to provide a method for manufacturing a cured product using the above curable resin composition.

A curable resin composition according to the present invention comprises:
a cyanate ester compound (A) represented by the following formula (I); and
a curing accelerator (B): 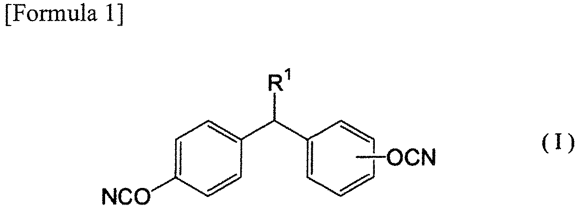 wherein R¹ represents a hydrocarbon group having 2 to 20 carbon atoms.

In an embodiment of the present invention, R¹ may be an alkyl group having 2 to 5 carbon atoms.

In an embodiment of the present invention, R¹ may be selected from the group consisting of an ethyl group, an i-propyl group, and a tert-butyl group.

In an embodiment of the present invention, the curing accelerator (B) may be a metal complex compound.

In an embodiment of the present invention, the metal complex compound may be a complex compound of a metal selected from the group consisting of cobalt, aluminium, copper, manganese, zirconium, and nickel.

In an embodiment of the present invention, the curing accelerator (B) may be contained in an amount of 0.01 to 1.0 parts by mass based on 100 parts by mass of the cyanate ester compound (A).

In an embodiment of the present invention, the curable resin composition may further comprise at least one cyanate ester compound (C) selected from the group consisting of the following formula (II): 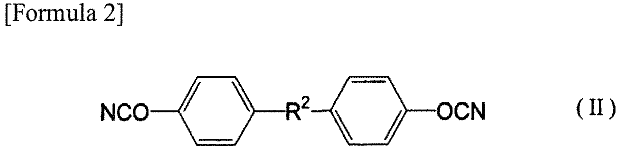 wherein R² is any one selected from the group consisting of the following formulae (i) to (v): 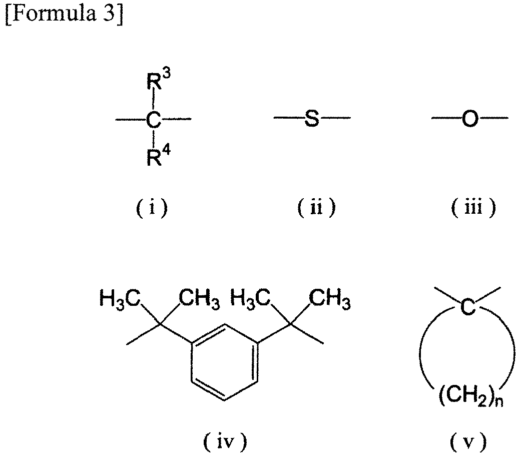 wherein each of R³ and R⁴ represents a hydrogen atom, or an alkyl group having 1 to 8 carbon atoms or a trifluoromethyl group; and n represents an integer of 4 to 7,
the following formula (III): 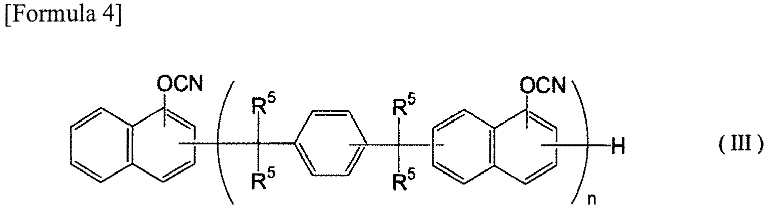 wherein R⁵ represent hydrogen or a methyl group; n represents an integer of 1 to 50; and the cyanate ester compound (C) represented by the general formula (III) may be a mixture of compounds each having a different n,
the following formula (IV): 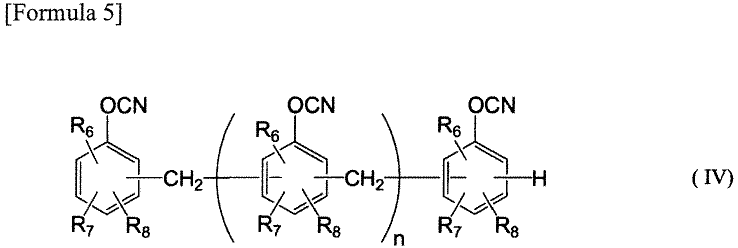 wherein R⁶ to R⁸ each independently represent a hydrogen atom, a hydrocarbon group having 1 to 6 carbon atoms, or a trifluoromethyl group; n represents an integer of 1 to 50; and the cyanate ester compound (C) represented by the general formula (IV) may be a mixture of compounds each having a different n, and
the following formula (V): 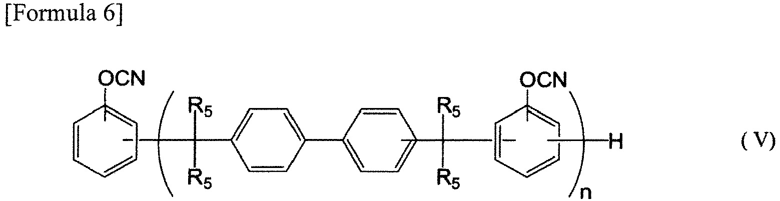 wherein R⁵ is as defined in the formula (III); n represents an integer of 1 to 50; and the cyanate ester compound (C) represented by the general formula (V) may be a mixture of compounds each having a different n.

In an embodiment of the present invention, the curable resin composition may further comprise one or more selected from the group consisting of an epoxy resin (D), a maleimide compound (E), a benzoxazine compound (F), and a compound (G) having a polymerizable unsaturated group.

A method for manufacturing a cured product according to another aspect of the present invention is a method for manufacturing a cured product using the above curable resin composition, and comprises a step of heating the curable resin composition at a temperature of 160 to 300°C to cure the curable resin composition.

In an embodiment of the present invention, the heating step may be performed in at least two steps.

In an embodiment of the present invention, the second or later heating step may be conducted at a temperature higher than that in the first heating step.

In another aspect of the present invention, there is also provided a cured product obtained by the above method.

In another aspect of the present invention, there are also provided a sealing material, an adhesive, and an insulating material which contain the above curable resin composition.

In another aspect of the present invention, there are also provided a prepreg containing: a base material; and the above curable resin composition impregnated into or coated on the base material, and a laminated sheet obtained by stacking and laminate-molding at least one prepreg.

According to the present invention, a curable resin composition which is in a liquid form at ordinary temperature and provides a cured product having excellent heat resistance and a low thermal expansion rate can be provided by using the specific bifunctional cyanate ester compound and the curing accelerator in combination.

### Brief Description of Drawings

[Figure 1] Figure 1 shows a ¹H-NMR chart of 1,1-bis(4-cyanatophenyl) isobutane obtained in Synthesis Example 1.
[Figure 2] Figure 2 shows a ¹H-NMR chart of 1,1-bis(4-cyanatophenyl) ethane obtained in Synthesis Example 2.

### Description of Embodiment

A curable resin composition according to the present invention contains a specific cyanate ester compound (A) and a curing accelerator (B) as indispensable ingredients. Hereinafter, individual ingredients will be described.

### <Cyanate Ester Compound (A)>

The cyanate ester compound (A) contained in the curable resin composition according to the present invention is represented by the following formula (I): 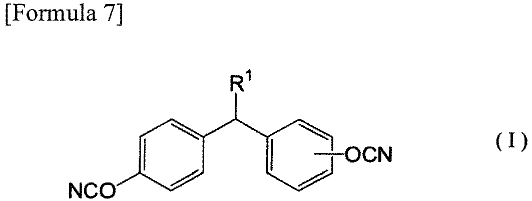 wherein R¹ represents a hydrocarbon group having 2 to 20 carbon atoms.

Examples of the cyanate ester compound represented by the above formula (I) include 1,1-bis(4-cyanatophenyl)propane, 1,1-bis(4-cyanatophenyl)butane, 1,1-bis(4-cyanatophenyl)-2-methylpropane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)isobutane, 1,1-bis(4-cyanatophenyl)hexane, 1,1-bis(4-cyanatophenyl)-4-methylpentane, 1,1-bis(4-cyanatophenyl)-3-methylpentane, 1,1-bis(4-cyanatophenyl)-2-methylpentane, 1,1-bis(4-cyanatophenyl)-2,3-dimethylbutane, 1,1-bis(4-cyanatophenyl)-3,3-dimethylbutane, bis(4-cyanatophenyl)cyclopentylmethane, bis(4-cyanatophenyl)cyclohexylmethane, bis(4-cyanatophenyl)phenylmethane, 1,1-bis(4-cyanatophenyl)heptane, 1,1-bis(4-cyanatophenyl)-2-methylhexane, 1,1-bis(4-cyanatophenyl)-3-methylhexane, 1,1-bis(4-cyanatophenyl)-4-methylhexane, 1,1-bis(4-cyanatophenyl)-5-methylhexane, 1,1-bis(4-cyanatophenyl)-3,4-dimethylpentane, 1,1-bis(4-cyanatophenyl)-2,3-dimethylpentane, 1,1-bis(4-cyanatophenyl)-3-ethylpentane, 1,1-bis(4-cyanatophenyl)-2-ethylpentane, bis(4-cyanatophenyl)-1-naphthylmethane, and 1,1-bis(4-cyanatophenyl)-2-phenylmethylhexane.

Among the above cyanate ester compounds, from the viewpoint of the viscosity, heat resistance, and coefficient of linear expansion of the resin composition, R¹ in the above formula (I) is preferably an alkyl group having 2 to 5 carbon atoms. Examples of the cyanate ester compound represented by the above formula (I) include include 1,1-bis(4-cyanatophenyl)propane, 1,1-bis(4-cyanatophenyl)butane, 1,1-bis(4-cyanatophenyl)-2-methylpropane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)isobutane, 1,1-bis(4-cyanatophenyl)-2,3-dimethylbutane, 1,1-bis(4-cyanatophenyl)-3,3-dimethylbutane, cyclopentylbis(4-cyanatophenyl)methane, cyclohexylbis(4-cyanatophenyl)methane, and bis(4-cyanatophenyl)phenylmethane. R¹ is more preferably 1,1-bis(4-cyanatophenyl)propane, 1,1-bis(4-cyanatophenyl)butane, 1,1-bis(4-cyanatophenyl)-2-methylpropane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)isobutane, 1,1-bis(4-cyanatophenyl)-2,3-dimethylbutane, 1,1-bis(4-cyanatophenyl)-3,3-dimethylbutane, and cyclopentylbis(4-cyanatophenyl)methane.

Above all, 1,1-bis(4-cyanatophenyl)propane, 1,1-bis(4-cyanatophenyl)-2-methylpropane, and 1,1-bis(4-cyanatophenyl)isobutane in which R¹ of the above formula (I) is an ethyl group, an i-propyl group, or a tert-butyl group are clear non-crystalline liquids, and have little change in physical properties under a high temperature environment, which are particularly preferable. The coefficient of linear expansion of a cured product of the curable resin composition using the above three cyanate ester compounds and the curing accelerator (B) in combination is smaller under a high temperature than that of a resin composition containing a dicyanatophenyl-based difunctional cyanate ester obtained by substituting hydrogen in a methylene group (-CHR¹-) with the other alkyl group or the like. Therefore, the curable resin composition can be suitably used for a resin for a liquid sealant having excellent heat resistance, and a resin for an insulating layer of a densified multilayer printed wiring board, or the like. Of course, needless to say, the curable resin composition according to the present invention may further contain the other difunctional cyanate ester compound other than those described above.

A method for producing the cyanate ester compound represented by the formula (I) is not particularly limited. A desired compound can be obtained by applying a method known as a cyanate synthesis method using a phenol represented by the following formula (VI). 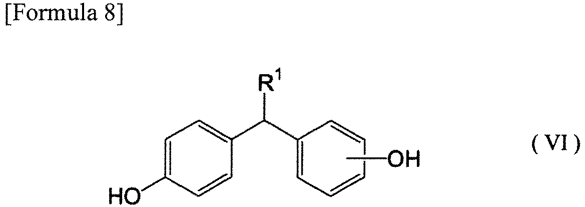 wherein R¹ is as defined in the above formula (I).

For example, the cyanate ester compound of the formula (I) can be obtained by cyanation of the phenol of the formula (V) according to a method described in IAN HAMERTON, "Chemistry and Technology of Cyanate Ester Resins" , BLACKIE ACADEMIC & PROFESSIONAL. The present invention can provide the cyanate ester compound by suitably using known methods such as a method in which a phenol compound is reacted with a cyanogen halide in a solvent in the presence of a base in such a state that the cyanogen halide is always present in excess over the base (U.S. Pat. No. 3,553,244); a method in which a cyanate ester compound is synthesized using a tertiary amine as a base in excess over a cyanogen halide (Japanese Patent Laid-Open No. H7-53497); a method in which a trialkylamine is reacted with a cyanogen halide by a continuous plug flow system (National Publication of International Patent Application No. 2000-501138); a method in which a phenol is reacted with a cyanogen halide in an nonaqueous solution in the presence of a tert-amine and a tert-ammonium halide produced as a by-product in this reaction is treated with an cation/anion exchange pair (National Publication of International Patent Application No. 2001-504835); a method which includes reacting a phenol compound with a tertiary amine and a cyanogen halide by simultaneous addition of the tertiary amine and the cyanogen halide in the presence of a solvent separable from water, conducting water washing and separation of the product solution, and purifying the resulting solution by precipitation using secondary or tertiary alcohols or poor solvents for hydrocarbons (Japanese Patent No. 2991054); and a method in which naphthols, a cyanogen halide, and a tertiary amine are reacted in a two-phase solvent composed of water and an organic solvent under acidic conditions (Japanese Patent Laid-Open No. 2007-277102). The cyanate ester compound obtained by the above methods can be identified by known methods such as NMR.

### <Curing Accelerator (B)>

The curable resin composition according to the present invention contains a curing accelerator as an indispensable ingredient. The above specific cyanate ester compound (A) and the curing accelerator (B) are used in combination, and thereby a temperature when the curable resin composition is cured can be lowered; the deterioration in a storage elastic modulus of the cured product is further suppressed; the coefficient of linear expansion of the cured product is small under a high temperature; and curability having excellent heat resistance can be obtained. Above all, because the coefficient of linear expansion of the cured product under a high temperature can be reduced as compared with the case where the curing accelerator (B) is not contained, the curable resin composition according to the present invention can be suitably used as the resin for the insulating layer of the densified multilayer printed wiring board.

Any conventionally known curing accelerator may be used as the curing accelerator (B) without particular limitation. For example, there can be used organometallic salts such as Cu, Fe, Co, Mn, Al, Ti, Zr, and Ni salts of octylic acid, stearic acid, naphthenic acid, acetylacetonate, and the like; alkoxides of metals such as Ti, Sn, Bi, Zr, and Al; phenol compounds such as octylphenol and nonylphenol; alcohols, such as 1-butanol and 2-ethylhexanol; imidazole derivatives such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, and 2-phenyl-4-methyl-5-hydroxymethylimidazole; amine compounds such as dicyandiamide, benzyldimethylamine, and 4-methyl-N,N-dimethylbenzylamine; and a phosphine-based or phosphonium-based phosphorus compound, or the like.

Among the above curing accelerators, from the viewpoint of the coefficient of linear expansion, a metal complex compound of cobalt, aluminium, copper, manganese, zirconium, or nickel can be suitably used. For example, there can be suitably used copper octoate, cobalt octoate, aluminum octoate, manganese octoate, copper stearate, cobalt stearate, aluminium stearate, copper naphthenate, cobalt naphthenate, aluminum naphthenate, manganese naphthenate, copper acetylacetone (II), cobalt acetylacetone (II), cobalt acetylacetone (III), iron acetylacetone (III), manganese acetylacetone (II), manganese acetylacetone (III), aluminium acetylacetone (III), zirconium acetylacetone (IV), nickel (II) acetylacetone, tetrabutoxyzirconium, tetrakis(2-ethyl-1,3-hexanediolato)titanium, titanium tetraisopropoxide, and tetra-n-butoxytitanium or the like. Particularly, there can be more preferably used cobalt stearate, copper acetylacetone (II), cobalt acetylacetone (II), cobalt acetylacetone (III), manganese acetylacetone (II), manganese acetylacetone (III), zirconium acetylacetone (IV), and nickel (II) acetylacetone.

The above curing accelerator (B) is preferably contained in an amount of 0.01 to 1.0 parts by mass based on 100 parts by mass of the cyanate ester compound (A). The curing accelerator (B) is contained in this range, and thereby the deterioration in the storage elastic modulus of the cured product is further suppressed; the coefficient of linear expansion of the cured product is small under a high temperature; and the cured product having excellent heat resistance can be obtained. The content of the curing accelerator is more preferably 0.01 to 0.5 parts by mass.

### <Other Ingredients>

A cyanate ester compound (C) other than the above cyanate ester compound (A) may be contained in the curable resin composition according to the present invention. Examples of the cyanate ester compound (C) include cyanate ester compounds represented by the following formulae (II) to (V). 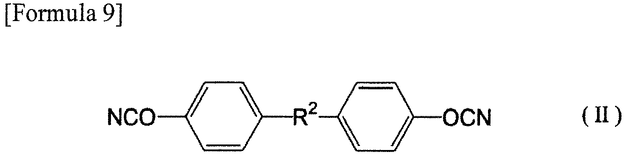 wherein R² is any one selected from the group consisting of the following formulae (i) to (v): 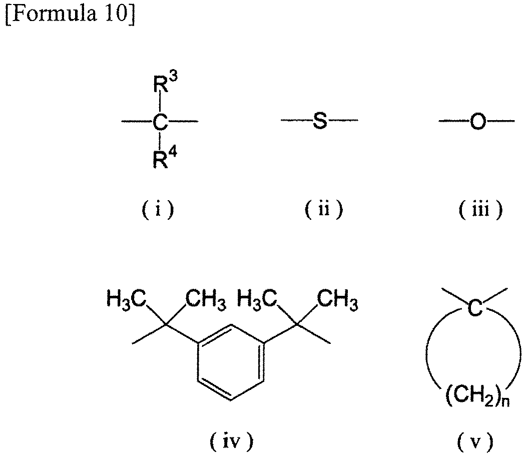 wherein each of R³ and R⁴ represents a hydrogen atom, or an alkyl group having 1 to 8 carbon atoms or a trifluoromethyl group; and n represents an integer of 4 to 7, 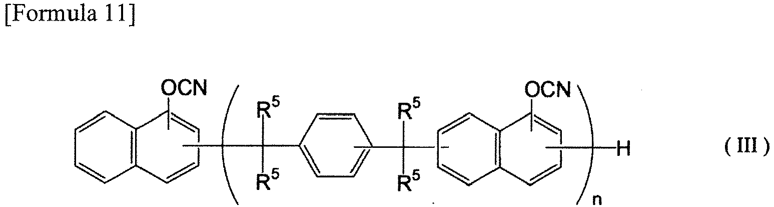 wherein R⁵ represent hydrogen or a methyl group; n represents an integer of 1 to 50; and the cyanate ester compound (C) represented by the general formula (III) may be a mixture of compounds each having a different n, 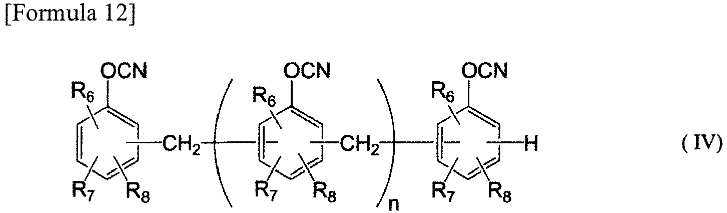 wherein R⁶ to R⁸ each independently represent a hydrogen atom, a hydrocarbon group having 1 to 6 carbon atoms, or a trifluoromethyl group; n represents an integer of 1 to 50, and the cyanate ester compound (C) represented by the general formula (IV) may be a mixture of compounds each having a different n, and 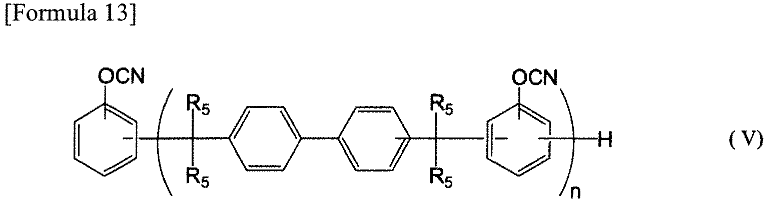 wherein R⁵ is as defined in the formula (III); n represents an integer of 1 to 50; and the cyanate ester compound (C) represented by the general formula (V) may be a mixture of compounds each having a different n.

The cyanate ester compound represented by the formula (II) can be obtained by cyanation of a phenol represented by the following formula (VII) according to the same method as that of the above cyanate ester compound. 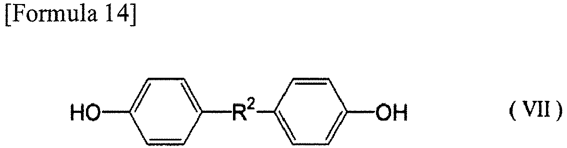 wherein R² is the same as the above definition.

The cyanate ester compound represented by the formula (III) can be obtained by cyanation of a phenol represented by the following formula (VIII) according to the same method as that of the above cyanate ester compound. 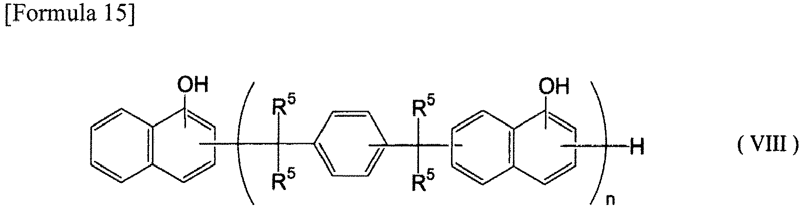 wherein R⁵ and n are the same as the above definitions.

The cyanate ester compound represented by the formula (IV) can be obtained by cyanation of a phenol represented by the general formula (IX) according to the same method as that of the above cyanate ester compound. 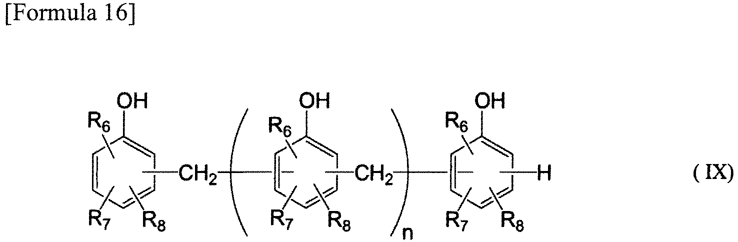 wherein R⁵ and n are as defined in the formula (III).

The cyanate ester compound represented by the above formula (V) can be obtained by cyanation of a phenol represented by the following formula (X) according to the same method as that of the above cyanate ester compound. 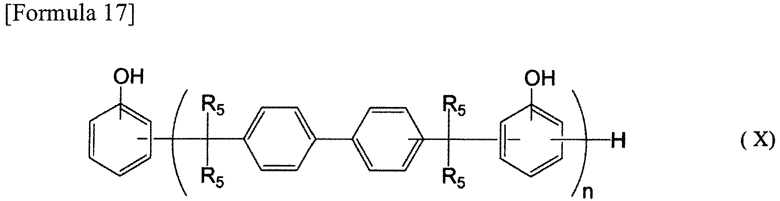 wherein R⁵ is as defined in the formula (III); n represents an integer of 1 to 50; and the cyanate ester compound may be a mixture of compounds each having a different n.

Any commonly known cyanate ester compound may be used as the cyanate ester compounds represented by the above formulae (II) to (V). Examples thereof include 2,2-bis(4-cyanatophenyl)propane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4'-cyanatophenyl)-1,1,1,3,3,3-hexafluoropropane, bis(4-cyanatophenyl)ether, bis(4-cyanatophenyl)sulfide, 1,3-bis(4-cyanato-α,α-dimethylbenzyl)benzene, 1,1-bis(4'-cyanatophenyl)cyclopentane, 1,1-bis(4'-cyanatophenyl)cyclohexane, a phenol novolac-based cyanate ester, a cresol novolac-based cyanate ester, a biphenyl aralkyl-based cyanate ester, and a naphthol aralkyl-based cyanate ester.

Among the above cyanate ester compounds, 2,2-bis(4-cyanatophenyl)propane, 2,2-bis(4-cyanatophenyl)butane, 2,2-bis(4-cyanatophenyl)hexane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)-2-methylpentane, 2,2-bis(4'-cyanatophenyl)-1,1,1,3,3,3-hexafluoropropane, bis(4-cyanatophenyl)ether, bis(4-cyanatophenyl)sulfide, 1,3-bis(4-cyanato-α,α-dimethylbenzyl)benzene, 1,1-bis(4'-cyanatophenyl)cyclopentane, 1,1-bis(4'-cyanatophenyl)cyclohexane, the phenol novolac-based cyanate ester, the cresol novolac-based cyanate ester, the biphenyl aralkyl-based cyanate ester, and the naphthol aralkyl-based cyanate ester are preferable. 2,2-bis(4-cyanatophenyl)propane, 2,2-bis(4-cyanatophenyl)butane, 2,2-bis(4-cyanatophenyl)-4-methylpentane, 2,2-bis(4'-cyanatophenyl)-1,1,1,3,3,3-hexafluoropropane, 1,3-bis(4-cyanato-α,α-dimethylbenzyl)benzene, bis(4-cyanatophenyl)ether, bis(4-cyanatophenyl)sulfide, 1,1-bis(4'-cyanatophenyl)cyclohexane, the phenol novolac-based cyanate ester, and the naphthol aralkyl-based cyanate ester are more preferable. These cyanate ester compounds can be used alone or in the form of a mixture of two or more.

Resins and compounds other than the cyanate ester compound may be contained in the curable resin composition according to the present invention. Examples thereof include an epoxy resin (D), a maleimide compound (E), a benzoxazine compound (F), and a compound (G) having a polymerizable unsaturated group.

Any commonly known compound having two or more epoxy groups per molecule may be used as the epoxy resin (D) contained as an optional ingredient in the curable resin composition. Examples thereof include a bisphenol A-based epoxy resin, a bisphenol F-based epoxy resin, a phenol novolac-based epoxy resin, a cresol novolac-based epoxy resin, a bisphenol A novolac-based epoxy resin, a brominated bisphenol A-based epoxy resin, a brominated phenol novolac-based epoxy resin, a trifunctional phenol-based epoxy resin, a tetrafunctional phenol-based epoxy resin, a naphthalene-based epoxy resin, a biphenyl-based epoxy resin, a phenol aralkyl-based epoxy resin, a biphenyl aralkyl-based epoxy resin, a naphthol aralkyl-based epoxy resin, an alicyclic epoxy resin, a polyol-based epoxy resin, a phosphorus-containing epoxy resin, glycidyl amine, glycidyl ester, a compound obtained by epoxidation of a double bond of butadiene or the like, and a compound obtained by a reaction of a hydroxyl group-containing silicone resins with epichlorohydrin. Among them, there are preferred the bisphenol A-based epoxy resin, the bisphenol F-based epoxy resin, the phenol novolac-based epoxy resin, the cresol novolac-based epoxy resin, the brominated bisphenol A-based epoxy resin, the brominated phenol novolac-based epoxy resin, the naphthalene-based epoxy resin, the biphenyl-based epoxy resin, the phenol aralkyl-based epoxy resin, the biphenyl aralkyl-based epoxy resin, the naphthol aralkyl-based epoxy resin, the alicyclic epoxy resin, the polyol-based epoxy resin, the phosphorus-containing epoxy resin, the glycidyl amine, and the glycidyl ester or the like. There are more preferred the bisphenol A-based epoxy resin, the bisphenol F-based epoxy resin, the naphthalene-based epoxy resin, the biphenyl-based epoxy resin, the phenol aralkyl-based epoxy resin, the biphenyl aralkyl-based epoxy resin, the naphthol aralkyl-based epoxy resin, and the alicyclic epoxy resin or the like. These epoxy resins can be used alone or in the form of a mixture of two or more.

A compound represented by the following formula (XI) may be suitably used as the maleimide compound (E) contained as an optional ingredient in the curable resin composition. 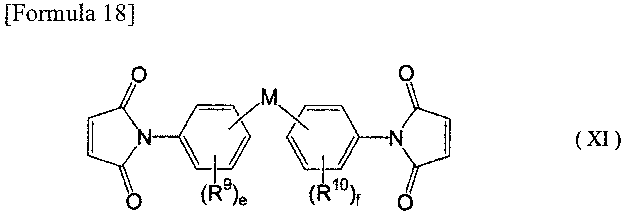 wherein R⁹ and R¹⁰ each independently represent a hydrogen atom, a halogen atom, and an alkyl group having 1 to 3 carbon atoms; e and f each represent an integer of 1 to 4; and M represents a single bond, or an alkylene group having 1 to 5 carbon atoms, an alkylidene group or an arylene group having 6 to 14 carbon atoms.

As the maleimide compound represented by the above formula (XI), bis(4-maleimidephenyl)methane, 2,2-bis[(4-(4-maleimidephenoxy)phenyl)]propane, bis(3,5-dimethyl-4-maleimidephenyl)methane, bis(3-ethyl-5-methyl-4-maleimidephenyl)methane, and bis(3,5-diethyl-4-maleimidephenyl)methane are preferable. Examples of the maleimide compound (D) include prepolymers of the above maleimide compounds, or a prepolymer of one of the maleimide compounds and an amine compound. These compounds and prepolymers can be used alone or in the form of a mixture of two or more as required.

A commonly known benzoxazine compound having two or more dihydrobenzoxazine rings per molecule may be used as the benzoxazine compound (F) contained as an optional ingredient in the curable resin composition. Examples thereof include a benzoxazine compound described in Japanese Patent Laid-Open No. 2009-096874. These benzoxazine compounds can be used alone or in the form of a mixture of two or more.

Commonly known polymerizable unsaturated group-containing compound may be used as the polymerizable unsaturated group-containing compound (G) contained as an optional ingredient in the curable resin composition. Examples thereof include vinyl compounds such as ethylene, propylene, styrene, divinylbenzene, and divinylbiphenyl; (meth)acrylates of mono- or polyhydric alcohols such as methyl(meth)acrylate, 2-hydroxyethyl(meth)acrylate, 2-hydroxypropyl(meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate; epoxy(meth)acrylates such as bisphenol A-based epoxy(meth)acrylate and bisphenol F-based epoxy(meth)acrylate; and benzocyclobutene resins. These unsaturated group-containing compounds can be used alone or in the form of a mixture of two or more.

So long as the effect of the curable resin composition according to the present invention is not impaired, the above ingredients (C) to (G) can be properly added depending upon applications. For example, 0 to 100 parts by mass of the cyanate ester compound (C), 0 to 500 parts by mass of the epoxy resin (D), 0 to 100 parts by mass of the maleimide compound (E), 0 to 100 parts by mass of the benzoxazine compound (F), and 0 to 100 parts by mass of the compound (G) having a polymerizable unsaturated group are preferably contained based on 100 parts by mass of the cyanate ester compound (A). The curable resin composition contains the compounds and the resins at the above ratios, and thereby the coefficient of linear expansion of the cured product is smaller under a high temperature, and the curable resin composition having excellent heat resistance can be obtained.

The curable resin composition according to the present invention may further contain an inorganic filler in addition to the above compounds and resins. Examples of the inorganic filler include silicates such as talc, calcined clay, uncalcined clay, mica, and glass; oxides such as titanium oxide, alumina, silica, and fused silica; carbonates such as calcium carbonate, magnesium carbonate, and hydrotalcite; hydroxides such as aluminum hydroxide, magnesium hydroxide, and calcium hydroxide; sulfates or sulfites such as barium sulfate, calcium sulfate, and calcium sulfite; borates such as zinc borate, barium metaborate, aluminum borate, calcium borate, and sodium borate; nitrides such as aluminum nitride, boron nitride, silicon nitride, and carbon nitride; and titanates such as strontium titanate and barium titanate. One of these can be used alone or two or more thereof may be used in combination. Among them, the silica is particularly preferable, and the fused silica is preferable in respect of an excellent low thermal expansibility. Although crushed and spherical silicas exist, the spherical silica is preferable in respect of lowering the melt viscosity of the resin composition.

The spherical silica may be further processed by a processing agent for previously performing a surface treatment. At least one compound selected from the group consisting of functional group-containing silanes, cyclic oligosiloxanes, organohalosilanes, and alkylsilazanes may be suitably used as the processing agent. Among them, the organohalosilanes and the alkylsilazanes are suitably used for the surface treatment of the spherical silica in order to make the surface of the silica hydrophobic and make the spherical silica in the curable resin composition preferable in respect of excellent dispersibility.

The functional group-containing silanes used as the processing agent are not particularly limited. Examples thereof include epoxysilane compounds such as 3-glycidoxypropyltrimetoxysilane, 3-glycidoxypropyltriethoxysilane, 3-glycidoxypropylmethyldiethoxysilane, and 2-(3,4-epoxycyclohexyl)ethyldimethoxysilane; (meth)acrylsilanes such as 3-methacryloxypropyltrimethoxysilane, 3-methacryloxypropylmethyldimethoxysilane, 3-methacryloxypropyltriethoxysilane, and 3-methacryloxypropylmethyldiethoxysilane; mercaptosilanes such as 3-mercaptopropyltrimethoxysilane, 3-mercaptopropyltriethoxysilane, and 3-mercaptopropylmethyldimethoxysilane; vinylsilanes such as vinyltriethoxysilane, vinyltrimetoxysilane, and vinyltrichlorosilane; isocyanate silanes such as 3-isocyanatepropyltriethoxysilane; ureidosilanes such as 3-ureidopropyltrimethoxysilane and 3-ureidopropyltriethoxysilane; (5-norbornene-2-yl)alkylsilanes such as (5-norbomene-2-yl)trimethoxysilane, (5-norbornene-2-yl)triethoxysilane, and (5-norbornene-2-yl)ethyltrimethoxysilane; and phenylsilanes such as phenyltrimethoxysilane.

A silicone resin powder may be added to the curable resin composition. The silicone resin powder is a cured product powder having a structure in which siloxane bonds are crosslinked in a three-dimensional network manner represented by (RSiO_{3/2})ₙ. The powder suitably has an average particle diameter of 0.1 to 10 µm. Specific examples thereof include KMP-590 (manufactured by Shin-Etsu Silicone), KMP-701 (manufactured by Shin-Etsu Silicone), X-52-854 (manufactured by Shin-Etsu Silicone), X-52-1621 (manufactured by Shin-Etsu Silicone), XC99-B5664 (manufactured by Momentive Performance Materials Inc.), XC99-A8808 (manufactured by Momentive Performance Materials Inc.), and Tospearl 120 (manufactured by Momentive Performance Materials Inc.). The powders can be used alone or in the form of a mixture of two or more as required.

The curable resin composition according to the present invention can be obtained by mixing the above cyanate ester compound (A) and curing accelerator (B), and the cyanate ester compound (C), the epoxy resin (D), the maleimide compound (E), and the benzoxazine compound (F) and/or the polymerizable unsaturated group-containing compound (G), which are optional ingredients described above, or various additives if needed, with a solvent using known mixers such as a high-speed mixer, a Nauta mixer, a ribbon type blender, a kneader, an intensive mixer, a universal mixer, a dissolver, and a static mixer. A method for adding the cyanate ester compound, the various additives, and the solvent upon mixing is not particularly limited.

### <Method for Manufacturing Cured Product>

A cured product according to the present invention can be obtained by curing the curable resin composition described above by heat and light or the like. For example, an arbitrary-shaped cured product can be obtained by melting the curable resin composition or dissolving the curable resin composition in a solvent, thereafter filling the curable resin composition into a mold, and curing the curable resin composition under an ordinary condition.

When the curable resin composition is cured by heat, the curable resin composition is preferably cured at 160 to 300°C, more preferably at 170 to 250°C, and still more preferably at 180 to 230°C. Heat curing is performed in the above temperature range, and thereby the deterioration in the storage elastic modulus of the cured product is further suppressed; the coefficient of linear expansion of the cured product is small under a high temperature; and the cured product having excellent heat resistance can be obtained.

In a method for manufacturing the cured product according to the present invention, a heating step may be conducted for a certain period of time in the above temperature range. The curable resin composition may be cured by so-called "step curing" performing a step of holding the curable resin composition at a certain heating temperature for a certain period of time twice or more. When curing is performed by the step curing, the second or later heating step is preferably conducted at a temperature higher than that in the first heating step. For example, the first heating step can be conducted at 80 to 150°C, and the second or later heating step can be conducted at 150 to 300°C. Such a heating step is conducted, and thereby the deterioration in the storage elastic modulus of the cured product is further suppressed; the coefficient of linear expansion of the cured product is small under a high temperature; and the cured product having excellent heat resistance can be obtained.

### <Application of Curable Resin Composition>

A sealing material can be manufactured using the above curable resin composition. A method for manufacturing the sealing material is not in particularly limited. The sealing material can be obtained by mixing the above ingredients using a known mixer. A method for adding the cyanate ester compound (A), the curing accelerator (B), the other optional ingredient, and a solvent or the like during mixing is not particularly limited.

An inorganic and/or organic fiber base material prepregs/prepreg can be manufactured using the curable resin composition according to the present invention. A method for manufacturing the prepreg is not particularly limited. A well-known method used for a printed wiring material can be applied. For example, a method for impregnating a resin composition varnish into an inorganic fiber base material and/or an organic fiber base material, drying the inorganic fiber base material and/or the organic fiber base material, and putting the inorganic fiber base material and/or the organic fiber base material into a B stage to form the prepreg can be applied.

The curable resin composition according to the present invention may be used to produce a metal-clad laminated sheet and a multilayer sheet. A method for producing the laminated sheets or the like is not particularly limited. The laminated sheet can be obtained by subjecting the above prepreg and a metal foil to heating pressure molding with the prepreg and the metal foil superposed. Although a heating temperature is not particularly limited, the heating temperature is preferably 65 to 300°C, and particularly preferably 120 to 270°C. Although a pressurizing pressure is not particularly limited, the pressurizing pressure is preferably 2 to 5 MPa, and more preferably 2.5 to 4 MPa.

A fiber-reinforced composite material can be produced using the curable resin composition according to the present invention. The form and arrangement of the reinforced fiber are not particularly limited, and may be suitably selected from a textile, a nonwoven fabric, a mat, a knit, a braid, a unidirectional strand, a roving, and a chopped strand or the like. A preform (one obtained by laminating woven base fabrics containing reinforced fibers, one obtained by integrally stitching the woven base fabrics by stitch threads, or a fiber structure such as a three-dimensional textile or a braided product) can also be applied as the form of the reinforced fiber. Specific examples of a method for producing the fiber-reinforced composite material include liquid composite molding methods, resin film infusion methods, filament winding methods, hand lay up methods, and pultrusion methods. Among them, in a resin transfer molding method which is one of the liquid composite molding methods, materials other than the preform such as a metal plate, a foam core, and a honeycomb core can be previously set in a forming die. Thereby, the resin transfer molding method can be adopted in various applications, and is preferably used when a composite material having a comparatively complicated shape is mass-produced in a short time.

Because the curable resin composition according to the present invention has an excellent low thermal expansibility and high heat resistance, the curable resin composition is extremely useful as a highly-functional polymer material. The curable resin composition is preferably used for electrical insulating materials, sealing materials, adhesives, lamination materials, resists, and built-up laminated sheet materials as materials having excellent thermal, electrical, and mechanical properties. Additionally, the curable resin composition is preferably used for fixing materials, structural members, reinforcing agents, and mold materials or the like in the fields of civil engineering-construction, electric/electronic applications, automobiles, railways, ships, aircraft, sporting goods, and arts-crafts or the like. Among them, the curable resin composition is suitably used for semiconductor sealing materials or adhesives for electronic parts, aircraft structural members, satellite structural members, and railway vehicle structural members which require a low thermal expansibility, flame resistance, and a high mechanical strength.

### Examples

Hereinafter, the present invention is described further specifically with reference to the following Examples, to which, however, the present invention should not be particularly limited.

### <Synthesis of Cyanate Ester Compound>

### Synthesis Example 1: Synthesis of 1,1-bis(4-cyanatophenyl)isobutane (abbreviated as Bis-IB CN)

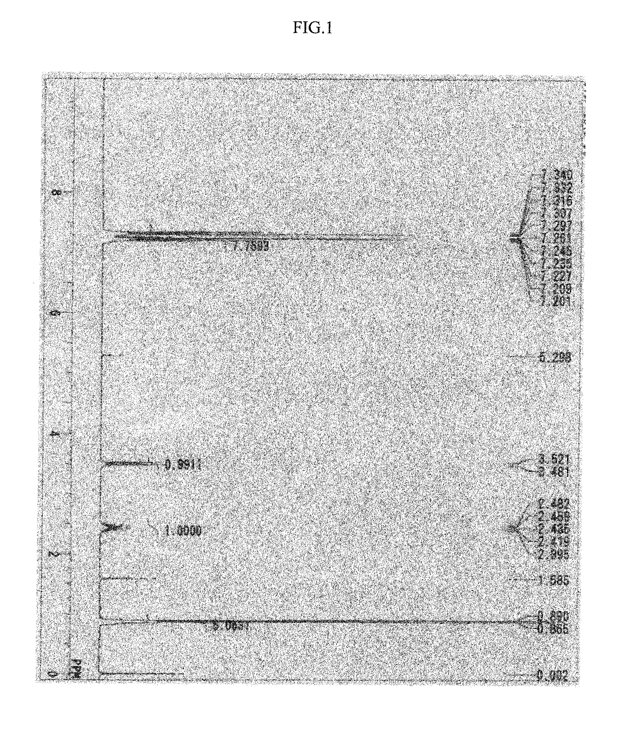

24.2 g (100 mmol) of 1,1-bis(4-hydroxyphenyl) isobutane (manufactured by Wako Pure Chemical Industries, Ltd.) and 28.3 g (280 mmol) of triethylamine were dissolved in 100 mL of tetrahydrofuran (solution 1). At -10°C, the solution 1 was dropwise added to a mixed solution of a methylene chloride solution (46.2 g) of cyanogen chloride (18.4 g (300 mmol)) and tetrahydrofuran (100 mL), over 1.5 hours. After the completion of the reaction was confirmed, the reaction liquid was condensed. The obtained crude product was dissolved in 300 mL of methylene chloride. The obtained liquid was washed with 1 M hydrochloric acid and distilled water, and was then dried with anhydrous magnesium sulfate. The methylene chloride was distilled away to obtain 28.3 g of desired 1,1-bis(4-cyanatophenyl)isobutane. The structure of the compound obtained as described above was identified by an NMR spectrum. The NMR spectrum was as shown in Figure 1.
1H-NMR: (270 MHz, Chloroform-d, internal reference TMS) δ (ppm) 0.88 (d, 6H), 2.41 (m, 1H), 3.51 (d,1H), 7.20-7.35 (complex, 8H)

### Synthesis Example 2: Synthesis of 1,1-bis(4-cyanatophenyl)ethane (abbreviated as Bis-E CN)

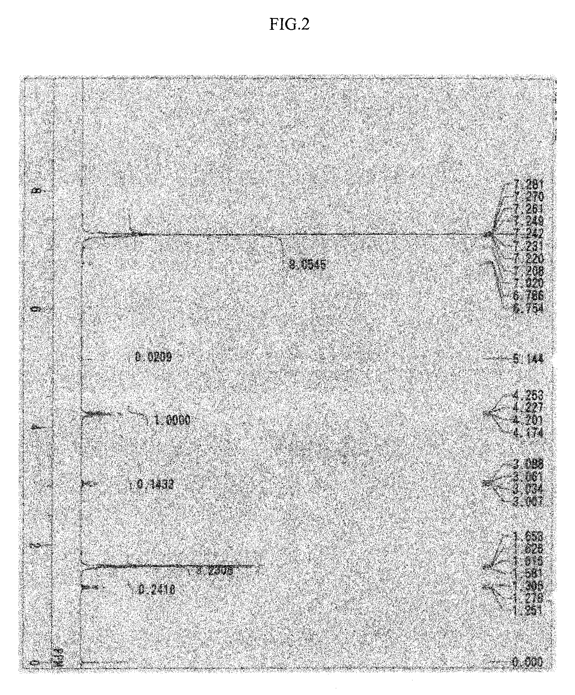

23.1 g of 1,1-bis(4-cyanatophenyl)ethane was obtained in the same manner as in Synthesis Example 1 except that 1,1-bis(4-hydroxyphenyl)ethane (manufactured by Wako Pure Chemical Industries, Ltd.) was used in place of 1,1-bis(4-hydroxyphenyl)isobutane. The structure of the compound obtained as described above was identified by an NMR spectrum. The NMR spectrum was as shown in Figure 2.
1H-NMR: (270 MHz, Chloroform-d, internal reference TMS)
δ (ppm) 1.62 (d, 3H), 4.22 (q, 1H), 7.42 (complex, 8H)

### Example 1

### <Preparation of Curable Resin Composition>

100 parts by mass of Bis-IB CN obtained in Synthesis Example 1, and 0.01 parts by mass of cobalt(III) acetylacetonate (manufactured by Wako Pure Chemical Industries, Ltd.) were mixed, heated, and degassed via a vacuum pump to obtain a composition. The presence of an insoluble portion at 50°C and the curing progress for the obtained composition were visually confirmed. The viscosity of the composition at 50°C was measured. Viscosity measurement was performed using a dynamic viscoelasticity measuring device (AR2000 manufactured by TA Instruments) on measurement conditions of an angular velocity of 10 rad/s and a geometry gap of 1 mm.

### <Production of Cured Product>

The composition obtained as described above was reheated. The composition was cast into a mold formed of a glass plate (120 mm x 120 mm x 5 mm), a polyimide film ("Kapton 200H" manufactured by DU PONT-TORAY CO., LTD.), and a fluoro rubber-made O ring ("S-100" manufactured by Morisei Kako Corporation). The composition was heated in an oven at 150°C for 1 hour, then heated at 200°C for 3 hours, and then heated at 250°C for 4 hours to cure the composition. After cooled, the polyimide film was removed by grinding, thereby obtaining a cured product.

### Example 2

A cured product was obtained in the same manner as in Example 1 except that the curing condition was changed to step curing at 130°C for 3 hours and at 250°C for 4 hours in Example 1.

### Example 3

A cured product was obtained in the same manner as in Example 1 except that the amount of cobalt(III) acetylacetonate to be blended was changed from 0.01 parts by mass to 0.5 parts by mass in Example 1.

### Example 4

A cured product was obtained in the same manner as in Example 1 except that 0.02 parts by mass of aluminium (III) acetylacetonate (manufactured by Tokyo Chemical Industry Co., Ltd.) was used in place of using 0.01 parts by mass of cobalt(III) acetylacetonate in Example 1.

### Example 5

A cured product was obtained in the same manner as in Example 4 except that copper(II) acetylacetonate (manufactured by Tokyo Chemical Industry Co., Ltd.) was used in place of aluminium(III) acetylacetonate in Example 4.

### Example 6

A cured product was obtained in the same manner as in Example 1 except that 0.06 parts by mass of manganese(II) acetylacetonate (manufactured by Tokyo Chemical Industry Co., Ltd.) was used in place of using 0.01 parts by mass of cobalt(III) acetylacetonate in Example 1.

### Example 7

A cured product was obtained in the same manner as in Example 6 except that zirconium(IV) acetylacetonate (manufactured by Tokyo Chemical Industry Co., Ltd.) was used in place of manganese(II) acetylacetonate in Example 6.

### Example 8

A cured product was obtained in the same manner as in Example 6 except that nickel(II) acetylacetonate (manufactured by Tokyo Chemical Industry Co., Ltd.) was used in place of manganese(II) acetylacetonate in Example 6, and the curing condition was changed to step curing at 180°C for 3 hours and at 250°C for 4 hours.

### Example 9

A cured product was obtained in the same manner as in Example 1 except that cobalt(III) acetylacetonate was not used in Example 1.

### Example 10

A cured product was obtained in the same manner as in Example 9 except that 100 parts by mass of Bis-E CN obtained in Synthetic Example 2 was used in place of using 100 parts by mass of Bis-IB CN in Example 9.

### Example 11

A cured product was obtained in the same manner as in Example 1 except that Bis-E CN obtained in Synthetic Example 2 was used in place of Bis-IB CN in Example 1, and the amount of cobalt(III) acetylacetonate to be blended was changed from 0.01 parts by mass to 0.02 parts by mass.

### Example 12

A cured product was obtained in the same manner as in Example 11 except that 0.06 parts by mass of aluminium(III) acetylacetonate (manufactured by Tokyo Chemical Industry Co., Ltd.) was used in place of using 0.02 parts by mass of cobalt(III) acetylacetonate in Example 11.

### Example 13

A cured product was obtained in the same manner as in Example 12 except that manganese(II) acetylacetonate was used in place of aluminium(III) acetylacetonate in Example 12.

### Example 14

A cured product was obtained in the same manner as in Example 11 except that 2,2-bis(4-cyanatophenyl)propane (manufactured by Mitsubishi Gas Chemical Co., Inc., abbreviated as Bis-A CN) was used in place of Bis-E CN in Example 11.

### Example 15

A cured product was obtained in the same manner as in Example 12 except that 2,2-bis(4-cyanatophenyl)propane (manufactured by Mitsubishi Gas Chemical Co., Inc., abbreviated as Bis-A CN) was used in place of Bis-E CN in Example 12.

### Example 16

A cured product was obtained in the same manner as in Example 14 except that copper(II) acetylacetonate was used in place of cobalt(III) acetylacetonate in Example 14, and the curing condition was changed to step curing at 180°C for 3 hours and at 250°C for 4 hours.

### Example 17

A cured product was obtained in the same manner as in Example 14 except that manganese(II) acetylacetonate was used in place of cobalt(III) acetylacetonate in Example 14, and the curing condition was changed to step curing at 180°C for 3 hours and at 250°C for 4 hours.

### Example 18

A cured product was obtained in the same manner as in Example 15 except that zirconium(IV) acetylacetonate was used in place of aluminium(III) acetylacetonate in Example 15.

### <Evaluation of Cured Products>

A change in a storage elastic modulus, a glass transition temperature, and a coefficient of linear expansion were measured for the cured products obtained as described above. The change in the storage elastic modulus and the glass transition temperature were measured in accordance with JIS-K7244-7-2007. Dynamic viscoelasticity measurement was conducted using a dynamic viscoelasticity measuring device (AR2000 manufactured by TA Instruments) on measurement conditions of a start temperature of 100°C, an end temperature of 350°C, a temperature increase rate of 3°C/min, and a measurement frequency of 1 Hz, to measure the change in the storage elastic modulus (G') and the glass transition temperature. The change in the storage elastic modulus and the glass transition temperature were defined as follows.

### (1) Change in Storage Elastic Modulus

The change in the storage elastic modulus was evaluated using a value obtained by dividing the storage elastic modulus at 350°C by the storage elastic modulus at 100°C. The obtained change in the storage elastic modulus was index-represented with the numerical value of Example 9 set to 100.

### (2) Glass Transition Temperature

The maximum value of loss tangent (tan δ) in the measurement temperature range was defined as the glass transition temperature.

### (3) Coefficient of Linear Expansion

The coefficient of linear expansion was measured in accordance with JIS-K-7197-1991. A test piece (5 mm x 5 mm x 5 mm) was set in a thermomechanical analyzer (TMA/SS7100 manufactured by SII NanoTechnology Inc.). Thermomechanical analysis was conducted in an expansion/compression mode on measurement conditions of a start temperature of 100°C, an end temperature of 300°C, a temperature increase rate of 5°C/min, and a load of 0.05 N, to measure an average thermal expansion amount per °C at 200°C to 300°C. The results of evaluation were as shown in Tables 1 and 2 below. The units of numerical values in Tables are represented by part by mass, and portions described as "-" mean that the relevant materials are not blended.

**[Table 1]**

| resin compositions | | Example 1 | Example 2 | Example 3 | Example 4 | Example 5 | Example 6 | Example 7 | Example 8 |
|---|---|---|---|---|---|---|---|---|---|
| cyanate esters | Bis-IB CN | 100 | 100 | 100 | 100 | 100 | 100 | 100 | 100 |
| | Bis-E CN | - | - | - | - | - | - | - | - |
| | Bis-A CN | - | - | - | - | - | - | - | - |
| curing accelerators | Co (III) acetylacetonato | 0.01 | 0.01 | 0.5 | - | - | - | - | - |
| | Al (III) acetylacetonato | - | - | - | 0.02 | - | - | - | - |
| | Cu (II) acetylacetonato | - | - | - | - | 0.02 | - | - | - |
| | Mn (II) acetylacetonato | - | - | - | - | - | 0.06 | - | - |
| | Zr (IV) acetylacetonato | - | - | - | - | - | - | 0.06 | - |
| | Ni (II) acetylacetonato | | | | - | - | - | - | 0.06 |
| curing conditions | 150°C (1h)→200°C (3h)→250°C (4h) | conduct | - | conduct | conduct | conduct | conduct | conduct | - |
| | 180°C (3h)→250°C (4h) | - | - | - | - | - | - | - | conduct |
| | 130°C (3h)→250°C (4h) | - | conduct | - | - | - | - | - | - |
| results of evaluation | property | clear solution | clear solution | clear solution | clear solution | clear solution | clear solution | clear solution | clear solution |
| | viscosity (mPa·s) | 77 | 77 | 77 | 77 | 77 | 76 | 76 | 76 |
| | change in storage elastic modulus | 193 | 173 | 172 | 162 | 141 | 259 | 115 | 192 |
| | Tg (°C) | 330 | 325 | 334 | 323 | 323 | 328 | 323 | 320 |
| | coefficient of linear expansion (ppm/°C) | 78 | 82 | 87 | 82 | 81 | 80 | 82 | 82 |

**[Table 2]**

| resin compositions | | Example 9 | Example 10 | Example 11 | Example 12 | Example 13 | Example 14 | Example 15 | Example 16 | Example 17 | Example 18 |
|---|---|---|---|---|---|---|---|---|---|---|---|
| cyanate esters | Bis-IB CN | 100 | - | - | - | - | - | - | - | - | - |
| | Bis-E CN | - | 100 | 100 | 100 | 100 | - | - | - | - | - |
| | Bis-A CN | - | - | - | - | - | 100 | 100 | 100 | 100 | 100 |
| curing accelerators | Co (III) acetylacetonato | - | - | 0.02 | - | - | 0.02 | - | - | - | - |
| | Al (III) acetylacetonato | - | - | - | 0.06 | - | - | 0.06 | - | - | - |
| | Cu (II) acetylacetonato | - | - | - | - | - | - | - | 0.02 | - | - |
| | Mn (II) acetylacetonato | - | - | - | - | 0.06 | - | - | - | 0.02 | - |
| | Zr (IV) acetylacetonato | - | - | - | - | - | - | - | - | - | 0.06 |
| | Ni (II) acetylacetonato | - | - | - | - | - | - | - | - | - | - |
| curing conditions | 150°C (1h)→200°C (3h)→250°C (4h) | conduct | conduct | conduct | conduct | conduct | conduct | conduct | - | - | conduct |
| | 180°C (3h)→250°C (4h) | - | - | - | - | - | - | - | conduct | conduct | - |
| | 130°C (3h)→250°C (4h) | - | - | - | - | - | - | - | - | - | - |
| results of evaluation | property | clear solution | clear solution | clear solution | clear solution | white solid | white solid | white solid | white solid | white solid | white solid |
| | viscosity (mPa·s) | 78 | 15 | 16 | 14 | 14 | - | - | - | - | - |
| | change in storage elastic modulus | 100 | 77 | 68 | 77 | 68 | 39 | 33 | 37 | 33 | 33 |
| | Tg(°C) | 313 | 283 | 274 | 283 | 274 | 304 | 289 | 296 | 292 | 289 |
| | coefficient of linear expansion (ppm/°C) | 93 | 122 | 125 | 126 | 121 | 96 | 101 | 98 | 99 | 96 |

## Claims

1. A curable resin composition comprising:
a cyanate ester compound (A) represented by the following formula (I); and
a curing accelerator (B): 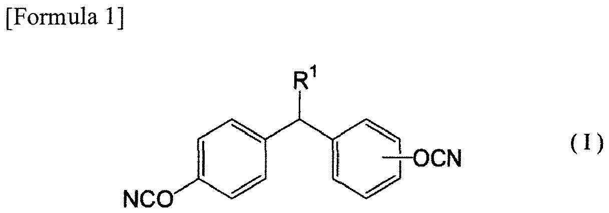
wherein R¹ represents a hydrocarbon group having 2 to 20 carbon atoms.

2. The curable resin composition according to claim 1, wherein R¹ is an alkyl group having 2 to 5 carbon atoms.

3. The curable resin composition according to claim 2, wherein R¹ is selected from the group consisting of an ethyl group, an i-propyl group, and a tert-butyl group.

4. The curable resin composition according to any one of claims 1 to 3, wherein the curing accelerator (B) is a metal complex compound.

5. The curable resin composition according to claim 4, wherein the metal complex compound is a complex compound of a metal selected from the group consisting of cobalt, aluminium, copper, manganese, zirconium, and nickel.

6. The curable resin composition according to any one of claims 1 to 5, wherein the curing accelerator (B) is contained in an amount of 0.01 to 1.0 parts by mass based on 100 parts by mass of the cyanate ester compound (A).

7. The curable resin composition according to any one of claims 1 to 6, further comprising at least one cyanate ester compound (C) selected from the group consisting of:
the following formula (II): 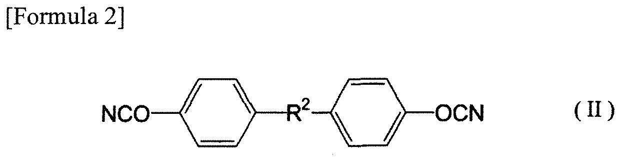 wherein R² is any one selected from the group consisting of the following formulae (i) to (v): 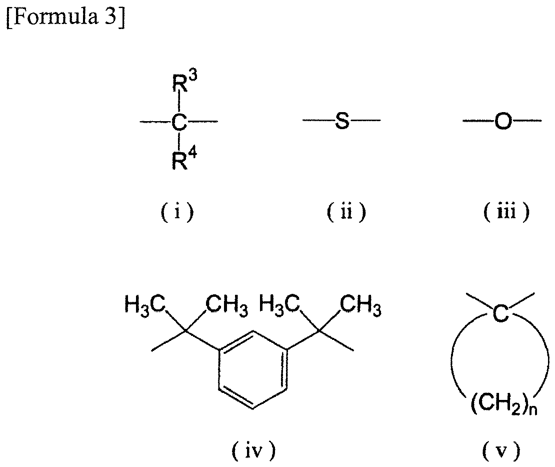 wherein each of R³ and R⁴ represents a hydrogen atom, or an alkyl group having 1 to 8 carbon atoms or a trifluoromethyl group; and n represents an integer of 4 to 7,
the following formula (III): 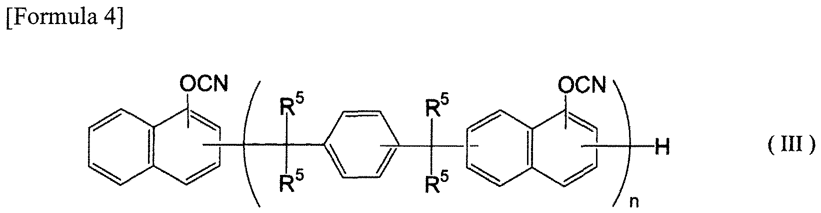 wherein R⁵ represent hydrogen or a methyl group; n represents an integer of 1 to 50; and the cyanate ester compound (C) represented by the general formula (III) may be a mixture of compounds each having a different n,
the following formula (IV): 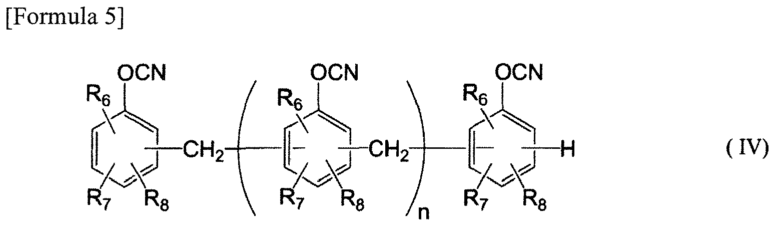 wherein R⁶ to R⁸ each independently represent a hydrogen atom, a hydrocarbon group having 1 to 6 carbon atoms, or a trifluoromethyl group; n represents an integer of 1 to 50; and the cyanate ester compound (C) represented by the general formula (IV) may be a mixture of compounds each having a different n, and
the following formula (V): 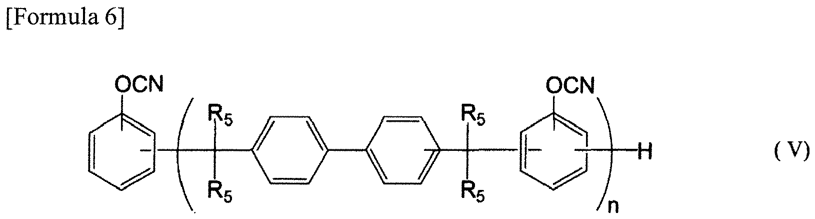 wherein R⁵ is as defined in the formula (III); n represents an integer of 1 to 50; and the cyanate ester compound (C) represented by the general formula (V) may be a mixture of compounds each having a different n.

8. The curable resin composition according to any one of claims 1 to 7, further comprising one or more selected from the group consisting of an epoxy resin (D), a maleimide compound (E), a benzoxazine compound (F), and a compound (G) having a polymerizable unsaturated group.

9. A method for manufacturing a cured product using the curable resin composition according to any one of claims 1 to 8,
the method comprising a step of heating the curable resin composition at a temperature of 160 to 300°C to cure the curable resin composition.

10. The method according to claim 9, wherein the heating step is performed in at least two steps.

11. The method according to claim 10, wherein a second or later heating step is conducted at a temperature higher than that in the first heating step.

12. A cured product obtained by the method according to any one of claims 9 to 11.

13. A sealing material comprising the curable resin composition according to any one of claims 1 to 8.

14. An adhesive comprising the curable resin composition according to any one of claims 1 to 8.

15. An insulating material comprising the curable resin composition according to any one of claims 1 to 8.

16. A prepreg comprising: a base material; and the curable resin composition according to any one of claims 1 to 8 impregnated into or coated on the base material.

17. A laminated sheet obtained by stacking and laminate-molding at least one prepreg according to claim 16.
